# EUROPÄISCHE PATENTSCHRIFT

(11) **EP 1 105 878 B1**
(45) Veröffentlichungstag und Bekanntmachung des Hinweises auf die Patenterteilung: **09.04.2003**
(21) Anmeldenummer: 99952260.0
(22) Anmeldetag: 02.08.1999
(51) Int. Cl.: G11C 11/14

(54) **SPEICHERZELLENANORDNUNG UND VERFAHREN ZU DEREN HERSTELLUNG**
MEMORY CELL ARRAY AND CORRESPONDING PRODUCTION METHOD
ENSEMBLE CELLULE DE MEMOIRE ET SON PROCEDE DE PRODUCTION

(30) Priorität: 12.08.1998 DE 19836567
(43) Veröffentlichungstag der Anmeldung: 13.06.2001
(73) Patentinhaber: Infineon Technologies AG, 81669 München (DE)
(72) Erfinder: SCHWARZL, Siegfried, D-85579 Neubiberg (DE)
(74) Vertreter: Fischer, Volker, Dipl.-Ing.
(86) Internationale Anmeldenummer: DE9902402
(87) Internationale Veröffentlichungsnummer: WO00010172

(56) Entgegenhaltungen:
- EP-A- 0 776 011
- EP-A- 0 875 901
- US-A- 5 039 655
- PATENT ABSTRACTS OF JAPAN vol. 014, no. 296 (P-1067), 26. Juni 1990 (1990-06-26) & JP 02 093373 A (NIPPON DENSO CO LTD), 4. April 1990 (1990-04-04)

## Beschreibung

Die Erfindung betrifft eine Speicherzellenanordnung mit Speicherelementen mit magnetoresistivem Effekt sowie ein Verfahren zu deren Herstellung.

Aus der Technologie Analyse, Magnetismus Band 2, XMR-Technologien, Technologiefrüherkennung, Verfasser Stefan Mengel, Herausgeber VDI-Technologiezentrum Physikalische Technologie, Zukünftige Technologien, Band 20, August 1997 sind Schichtstrukturen mit magnetoresistivem Effekt bekannt. Je nach Aufbau der Schichtstruktur wird unterschieden zwischen GMR-Element, TMR-Element, AMR-Element und CMR-Element. Der Begriff GMR-Element wird in der Fachwelt für Schichtstrukturen verwendet, die mindestens zwei ferromagnetische Schichten und eine dazwischen angeordnete nichtmagnetische, leitende Schicht aufweisen und den GMR-(giant magnetoresistance)-Effekt, das heißt, einen im Vergleich zum AMR-(anisotropic magnetoresistance)-Effekt großen magnetoresistiven Effekt zeigen. Unter dem GMR-Effekt wird die Tatsache verstanden, daß der elektrische Widerstand des GMR-Elements sowohl für Ströme parallel (CIP current in plane) als auch senkrecht (CPP current perpendicular to plane) zu den Schichtebenen abhängig davon ist, ob die Magnetisierungen in den beiden ferromagnetischen Schichten parallel oder antiparallel ausgerichtet sind. Der Widerstand ändert sich dabei abhängig von der Ausrichtung der Magnetisierungen um ΔR/R = 5 Prozent bis 20 Prozent bei Raumtemperatur.

Der Begriff TMR-Element wird in der Fachwelt für "Tunneling Magnetoresistance"-Schichtstrukturen verwendet, die mindestens zwei ferromagnetische Schichten und eine dazwischen angeordnete isolierende, nichtmagnetische Schicht aufweisen. Die isolierende Schicht ist dabei so dünn, daß es zu einem Tunnelstrom zwischen den beiden ferromagnetischen Schichten kommt. Diese Schichtstrukturen zeigen ebenfalls einen magnetoresistiven Effekt, der durch einen spinpolarisierten Tunnelstrom durch die zwischen den beiden ferromagnetischen Schichten angeordnete isolierende, nichtmagnetische Schicht bewirkt wird. Auch in diesem Fall ist der elektrische Widerstand des TMR-Elementes (CPP-Anordnung) abhängig davon, ob die Magnetisierungen in den beiden ferromagnetischen Schichten parallel oder antiparallel ausgerichtet sind. Der Widerstand variiert um ΔR/R = 10 Prozent bis ca. 30 Prozent bei Raumtemperatur.

Der AMR-Effekt äußert sich dadurch, daß der Widerstand in magnetisierten Leitern parallel und senkrecht zur Magnetisierungsrichtung verschieden ist. Er ist ein Volumeneffekt und tritt somit in ferromagnetischen Einfachschichten auf.

Ein weiterer Magnetowiderstandseffekt, der wegen seiner Größe (um ΔR/R = 100 Prozent bis 400 Prozent bei Raumtemperatur) Colossal Magnetoresistance-Effekt genannt wird, erfordert wegen seiner hohen Koerzitivkräfte ein hohes Magnetfeld zum Umschalten zwischen den Magnetisierungszuständen.

Es ist vorgeschlagen worden (siehe zum Beispiel D. D. Tang, P. K. Wang, V. S. Speriosu, S. Le, K. K. Kung, "Spin Valve RAM Cell", IEEE Transactions on Magnetics, Vol. 31, No. 6, Nov. 1996, Seite 3206), GMR-Elemente als Speicherelemente in einer Speicherzellenanordnung zu verwenden. Die Magnetisierungsrichtung der einen ferromagnetischen Schicht der GMR-Elemente wird dabei zum Beispiel durch eine benachbarte antiferromagnetische Schicht festgehalten. Es sind x- und y-Leitungen vorgesehen, die sich kreuzen. An den Kreuzungspunkten der x/y-Leitungen ist jeweils ein Speicherelement angeordnet. Zum Einschreiben von Information werden die x/y-Leitungen mit Signalen beaufschlagt, die am Kreuzungspunkt ein für die Ummagnetisierung ausreichendes magnetisches Feld verursachen. Zum Auslesen der Information können die x/y-Leitungen mit einem Signal beaufschlagt werden, durch das die betreffende Speicherzelle zwischen den beiden Magnetisierungszuständen hin und her geschaltet wird. Gemessen wird der Strom durch das Speicherelement, aus dem der Widerstandswert und damit die Information ermittelt wird.

Zum Schreiben und Lesen sind dabei lokale Magnetfelder von 10 Oe bis etwa 100 Oe entsprechend 8 A/cm bis 80 A/cm erforderlich. Dabei ist es erstrebenswert, die Magnetfelder durch möglichst geringe Ströme in den Leitungen zu erzeugen.

Mit fortschreitender Miniaturisierung werden die zur Erzeugung der lokalen Magnetfelder erforderlichen Stromdichten jedoch größer. Zusätzlich ist der Effekt beobachtet worden (siehe M. H. Kryder, Kie Y. Ahn, N. J. Mazzeo, S. Schwarzl, and S. M. Kane, "Magnetic Properties and Domain Structures in Narrow NiFe Stripes", IEEE Transactions on Magnetics, Vol. Mag.-16, No. 1, Janur 1980, Seite 99), daß die magnetischen Schaltfeldschwellen mit kleiner werdenden Dimensionen zunehmen, also höhere Ströme zum Schalten erforderlich werden.

In der EP-A-0 776 011 ist ein Speicher mit einer magnetoresistiven Speicherzelle gezeigt, bei der das magnetoresistive Speicherelement in einer Ebene von Leitungen angeordnet ist, die auf einem Substrat verlaufen. Die Leitungen sowie das magnetoresistive Speicherelement werden von einer Isolationsschicht bedeckt. Auf der Isolationsschicht verläuft eine weitere Leitung, die von einer Art Joch aus magnetischem Material umgeben ist, um das Magnetfeld zu verstärken. Das Joch umfaßt beabstandete Bereiche, die auf der ersten Leitung aufliegen und von oben her von der Isolationsschicht bedeckt sind. Die Ansprüche wurden gegen dieses Dokument abgegrenzt.

In Patent Abstracts of Japan, Band 14, Nr. 296, P-1067 (JP-A-02-093373) ist ein Meßelement zum Bestimmen des Stromflusses durch einen Leiter gezeigt. Das Meßelement umfaßt ein Joch sowie ein Magnetsensorelement. Das Meßelement dient nicht zur Informationsspeicherung.

In der US-A-5 039 655 ist ein Speicherzellenfeld gezeigt, bei dem an Kreuzungsstellen zwischen ersten und zweiten Leitungen jeweils Speicherelemente mit magnetoresistivem Effekt angeordnet sind.

Der Erfindung liegt daher das Problem zugrunde, eine Speicherzellenanordnung mit Speicherelement mit magnetoresistivem Effekt anzugeben, die mit geringeren Strömen und Stromdichten als im Stand der Technik programmierbar ist. Ferner soll ein Verfahren zur Herstellung einer derartigen Speicherzellenanordnung angegeben werden.

Dieses Problem wird erfindungsgemäß gelöst durch eine Speicherzellenanordnung gemäß Anspruch 1 sowie durch ein Verfahren zu deren Herstellung gemäß Anspruch 10. Weitere Ausgestaltungen der Erfindung gehen aus den übrigen Ansprüchen hervor.

In der Speicherzellenanordnung sind mindestens eine erste Leitung, eine zweite Leitung und ein Speicherelement mit magnetoresistivem Effekt vorgesehen, das an einer Kreuzungsstelle zwischen der ersten Leitung und der zweiten Leitung angeordnet ist. Vorzugsweise ist das Speicherelement zwischen die erste Leitung und die zweite Leitung geschaltet. Ferner ist ein Joch vorgesehen, das mindestens eine der Leitungen teilweise umgibt und das magnetisierbares Material mit einer relativen Permeabilität von mindestens 10 enthält. Das Joch ist so angeordnet, daß sich der Magnetfluß durch das Joch im wesentlichen über das Speicherelement schließt. Zum Schreiben der Speicherzelle werden die erste Leitung und die zweite Leitung so mit Strom beaufschlagt, daß durch Überlagerung der Magnetfelder der ersten Leitung und der zweiten Leitung am Ort des Speicherelementes ein Magnetfeld erzeugt wird, das die Schaltschwelle des Speicherelementes übersteigt.

Das Joch wird dabei durch das Magnetfeld der stromdurchflossenen Leitung, die von dem Joch teilweise umgeben ist, magnetisiert. Dadurch wird die Induktionsflußdichte B um einen Faktor µᵣ, der relativen Permeabilität, vergrößert. Dadurch entstehen magnetische Pole an den Stirnflächen des Jochs, zwischen denen ein magnetisches Feld erzeugt wird. Dieses magnetische Feld nimmt abhängig von der Wahl des Materials des Jochs sehr hohe Werte an und wird zum Schalten des Speicherelementes genutzt. Bei gleicher Stromdichte in der Leitung werden somit erheblich höhere magnetische Felder zum Schalten des Speicherelementes erzielt.

Das Joch kann aus allen ferromagnetischen und ferrimagnetischen Materialien gebildet werden.

Das Joch wird vorzugsweise aus weichmagnetischen, ferromagnetischen Schichten, insbesondere aus Fe, Ni, Co, Mn, MnBi, Fe-Si-, FeNi-, FeCo-, FeAl-Legierungen oder weichmagnetischen Ferriten gebildet.

Die Verwendung eines Magnetflußkonzentrators in einer Speicherzellenanordnung ist zwar in US-PS 4 455 626 bereits vorgeschlagen worden. Dort wird als Speicherelement eine Schicht verwendet, in der die Magnetisierung in Abhängigkeit der Information durch zwei benachbarte Schreibleitungen geändert wird. Zum Auslesen der Information ist ein magnetoresistiver Sensor vorgesehen, der unterhalb der Speicherschicht zusammen mit einer Leseleitung im Spalt einer als Magnetfeldkonzentrator bezeichneten planaren Schicht aus magnetisierbarem Material angeordnet ist. Durch diesen Magnetfeldkonzentrator wird der magnetische Fluß der Speicherschicht auf den magnetoresistiven Sensor konzentriert. Die Anordnung ist nicht dafür vorgesehen und geeignet, die Wirksamkeit der Ströme in den linearen Schreibleitungen für das Ummagnetisieren der magnetischen Speicherschicht zu erhöhen.

In der erfindungsgemäßen Speicherzellenanordnung sind als Speicherelement alle bekannten TMR-Elemente und GMR-Elemente in CPP-Anordnung (current perpendicular to plane) geeignet. Der GMR-Effekt ist größer, wenn der Strom senkrecht durch den Schichtstapel fließt (CPP), als wenn der Strom parallel in den Schichten (CIP current in plane) fließt. Darüber hinaus sind alle XMR-Elemente geeignet, die mindestens zwei Magnetisierungszustände mit unterschiedlichem Widerstand aufweisen, zwischen durch Anlegen eines Magnetfeldes, dessen Höhe für die Speicheranwendung verträglich ist, hin und her geschaltet werden kann. Insbesondere ist die Verwendung von CMR-Elementen möglich, da durch das Joch die erforderlichen Magnetfeldstärken erzielbar sind.

Vorzugsweise weisen die Speicherelemente jeweils zwei ferromagnetische Schichten und eine dazwischen angeordnete nichtmagnetische, isolierende (TMR) bzw. leitende (GMR) Schicht auf. Die ferromagnetischen Schichten weisen jeweils zwei Magnetisierungszustände auf. Es ist vorteilhaft, eine isolierende, nicht magnetische Schicht zu verwenden (TMR-Element), weil dadurch höhere Elementwiderstände (≥ 100 KΩ) erzielbar sind, die hinsichtlich des Leistungsverbrauchs und Signal/Rauschverhältnis günstiger sind.

Eine der ferromagnetischen Schichten ist vorzugsweise einer antiferromagnetischen Schicht benachbart angeordnet, die die Magnetisierungsrichtung in der benachbarten ferromagnetischen Schicht fixiert. Für die antiferromagnetische Schicht sind unter anderem Materialien geeignet, die mindestens eines der Elemente Fe, Mn, Ni, Cr, Co, V, Ir, Tb und O enthalten.

Alternativ können die Speicherelemente jeweils zwei ferromagnetische Schichten und eine dazwischen angeordnete nichtmagnetische Schicht aufweisen, wobei eine der ferromagnetischen Schichten magnetisch härter als die andere ferromagnetische Schicht ist, das heißt, daß nur eine ferromagnetische Schicht ummagnetisiert wird, während die andere unbeeinflußt bleibt. Die nichtmagnetische Schicht kann isolierend oder nicht isolierend sein.

Alternativ weisen die beiden ferromagnetischen Schichten im wesentlichen dieselbe Materialzusammensetzung auf, wobei die Magnetisierung in einer der ferromagnetischen Schichten über das Joch gezielt umgeschaltet werden kann.

Für die ferromagnetischen Schichten sind unter anderem Materialien geeignet, die mindestens eines der Elemente Fe, Ni, Co, Cr, Mn, Gd, Dy enthalten. Die Dicke der ferromagnetischen Schichten bei GMR-Elementen in CIP-Anordnung liegt vorzugsweise im Bereich zwischen 2 und 10 nm. Bei GMR- und TMR-Elementen in CPP-Anordnung können die Dicken der ferromagnetischen Schichten auch größer sein (zum Beispiel 100 bis 200 nm). Für die nichtmagnetische Schicht, die als Tunnelisolator wirkt, ist als isolierendes Material Al₂O₃, MgO, NiO, HfO₂, TiO₂, NbO oder SiO₂ geeignet. Als nichtisolierendes Material für die nichtmagnetische Schicht ist Cu oder Ag geeignet. Die Dicke-der nichtmagnetischen Schicht liegt im Bereich zwischen 1 und 4 nm, vorzugsweise zwischen 2 und 3 nm.

Die Speicherelemente weisen vorzugsweise Abmessungen im Bereich zwischen 0,05 µm und 20 µm auf. Sie können unter anderem quadratisch oder langgestreckt ausgestaltet sein.

Es ist vorteilhaft, ein Substrat zur Herstellung der Speicherzelle zu verwenden, das eine Trägerscheibe insbesondere aus Halbleitermaterial, speziell monokristallinem Silizium, umfaßt, da in diesem Fall die integrierte Speicherzellenanordnung mit den Verfahren der Siliziumprozeßtechnik herstellbar ist. Dadurch ist eine hohe Packungsdichte in der Speicherzellenanordnung erzielbar. Darüber hinaus kann die Peripherie ebenfalls in dem Substrat integriert sein.

Gemäß einer Ausgestaltung der Erfindung weist das Substrat auf der Trägerscheibe eine erste isolierende Schicht auf, die mit einem Graben versehen ist. In dem Graben verläuft die erste Leitung. Oberhalb der ersten Leitung ist das Speicherelement angeordnet und oberhalb des Speicherelementes die zweite Leitung. Das Joch umgibt die erste Leitung. Es grenzt an die Seiten und an den Boden des Grabens an und ist durch eine Schichtabscheidung nach der Bildung des Grabens in der ersten isolierenden Schicht herstellbar. Umgibt ein weiteres Joch die zweite Leitung, so grenzt es an die Seiten und die dem Speicherelement abgewandte Oberfläche der zweiten Leitung an und ist durch eine Schichtabscheidung und Spacerätzungen herstellbar.

Vorzugsweise sind ein erstes Joch und ein zweites Joch vorgesehen, die wie das Joch bzw. das weitere Joch ausgebildet sind, und von denen das erste Joch die erste Leitung teilweise umgibt und das zweite Loch die zweite Leitung teilweise umgibt. Sowohl das erste Joch als auch das zweite Joch sind so angeordnet, daß ein magnetischer Fluß durch das erste Joch bzw. das zweite Joch sich im wesentlichen über das Speicherelement schließt. Diese Ausgestaltung hat den Vorteil, daß sowohl das von der stromdurchflossenen ersten Leitung erzeugte Magnetfeld als auch das von der stromdurchflossenen zweiten Leitung erzeugte Magnetfeld über das erste Joch bzw. das zweite Joch ein verstärktes Magnetfeld am Ort des Speicherelementes bewirkt.

In der Speicherzellenanordnung wird die Speicherzelle durch die erste Leitung und die zweite Leitung, zwischen die das Speicherelement geschaltet ist, ausgewählt. Der Verlauf der ersten Leitung und der zweiten Leitung zueinander kann im Bereich des Speicherelementes sowohl parallel auch senkrecht zueinander sein. Entsprechend überlagern sich am Ort des Speicherelementes parallel ausgerichtete Magnetfelder oder senkrecht zueinander ausgerichtete Magnetfelder.

Zur Erzielung hoher Speicherdichten ist es vorteilhaft, eine Vielzahl Speicherelemente mit Joch, erster Leitungen und zweiter Leitungen vorzusehen. Die Speicherelemente, die vorzugsweise rasterförmig angeordnet sind, sind jeweils an einer Kreuzungsstelle zwischen einer der ersten Leitungen und einer der zweiten Leitungen angeordnet.

Da in der erfindungsgemäßen Speicherzellenanordnung bei gegebener Stromstärke erheblich höhere, mindestens um einen Faktor 10 bis 100, lokale Magnetfelder erzeugt werden, treten in den Leitungen bei gleichem Leitungsquerschnitt erheblich geringere Stromdichten auf. Auch bei starker Miniaturisierung der Speicherzellenanordnung liegen die erforderlichen Stromdichten unter der durch Elektromigration bestimmten Grenze.

Da erhöhte lokale Magnetfelder bei gleicher Stromstärke erzielbar sind, können für das Speicherelement auch magnetisch härtere Schichten, die eine wesentlich höhere Koerzitivfeldstärke als 10 Oe aufweisen, verwendet werden. Speicherelemente aus magnetisch härteren Schichten haben den Vorteil, daß sie gegenüber äußeren magnetischen Störungen unempfindlicher sind. Damit werden geringere Anforderungen an die Magnetfeldabschirmung gestellt. Ferner verringert sich die Gefahr eines Datenverlustes.

Durch die geringeren Stromdichten ist eine Vergrößerung der Höhe der Leitungen und damit der Aspektverhältnisse nicht erforderlich. Die Speicherzellenanordnung ist daher auch für Stapelanordnungen zur Erhöhung der Speicherdichte geeignet.

Bedingt durch die geringere Stromstärke, die erforderlich ist, um das gleiche magnetische Feld zu erzeugen, kann der Leistungsverbrauch bei den Schreib- und Lesevorgängen erheblich gesenkt werden.

Im folgenden wird die Erfindung anhand von Ausführungsbeispielen, die in den Figuren 3 bis 8 dargestellt sind, näher erläutert.
- Figur 1a: zeigt einen Schnitt durch ein Speicherelement, das zwischen eine erste Leitung und eine zweite Leitung geschaltet ist, wobei ein Joch eine der Leitungen teilweise umgibt.
- Figur 1b: zeigt einen Schnitt durch das in Figur 1a dargestellte Joch.
- Figur 2a: zeigt ein Speicherelement, das zwischen eine erste Leitung und eine zweite Leitung geschaltet ist, wobei die erste Leitung teilweise von einem Joch umgeben ist.
- Figur 2b: zeigt einen Schnitt durch das in Figur 2a gezeigte Joch und das Speicherelement.
- Figur 3: zeigt einen Schnitt durch ein Substrat nach einer Grabenätzung unter Abscheidung einer ferromagnetischen Schicht.
- Figur 4: zeigt den in Figur 3 dargestellten Schnitt durch das Substrat nach Bildung eines ersten Joches und einer ersten Leitung im Graben.
- Figur 5: zeigt den in Figur 4 dargestellten Schnitt durch das Substrat nach Bildung einer ersten ferromagnetischen Schicht, die von einer isolierenden Schicht umgeben ist.
- Figur 6a: zeigt den in Figur 5 dargestellten Schnitt durch das Substrat nach Bildung einer Tunnelschicht und einer zweiten ferromagnetischen Schicht.
- Figur 6b: zeigt den in Figur 6a mit b-b bezeichneten Schnitt nach Abscheidung einer isolierenden Schicht und Ausbildung eines zweiten Grabens. Der in Figur 6a dargestellte Schnitt ist in Figur 6b mit a-a bezeichnet.
- Figur 7: zeigt den in Figur 6b dargestellten Schnitt nach Bildung von Spacern und einer zweiten Leitung oberhalb der zweiten ferromagnetischen Schicht.
- Figur 8: zeigt den in Figur 7 dargestellten Schnitt durch das Substrat nach Bildung einer Deckschicht oberhalb der zweiten Leitung, die gemeinsam mit den Spacern ein zweites Joch bildet.
- Figur 9: zeigt einen Ausschnitt aus einer Speicherzellenanordnung, die als Speicherelemente magnetoresistive Elemente aufweist.

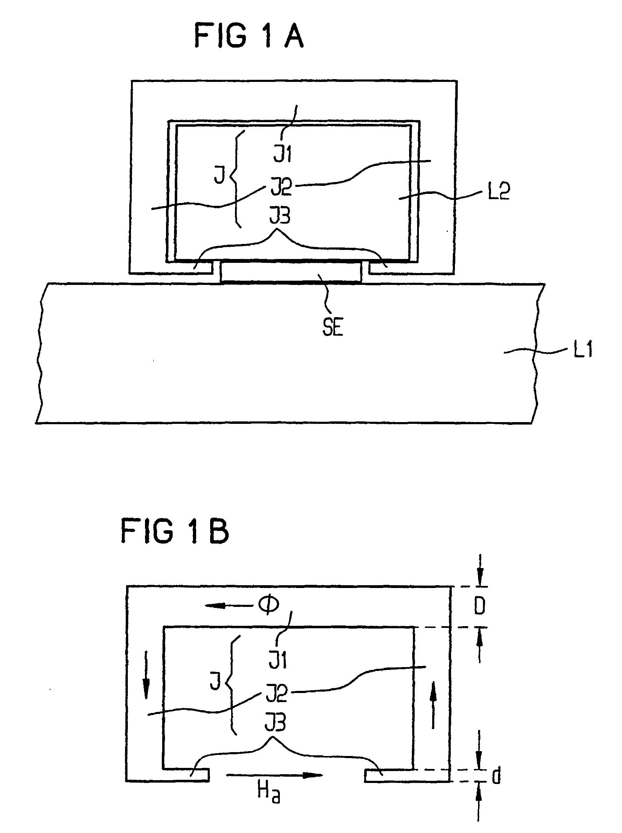

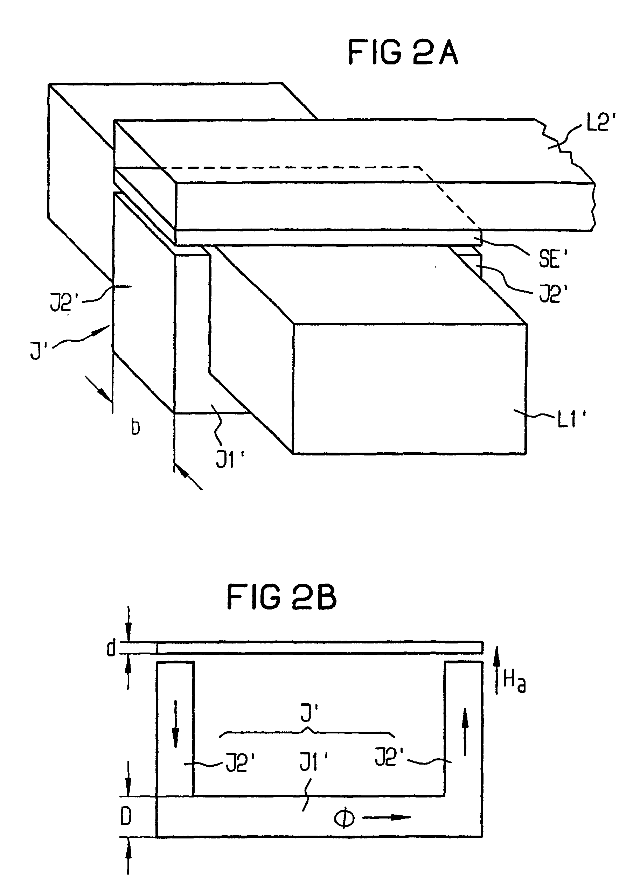

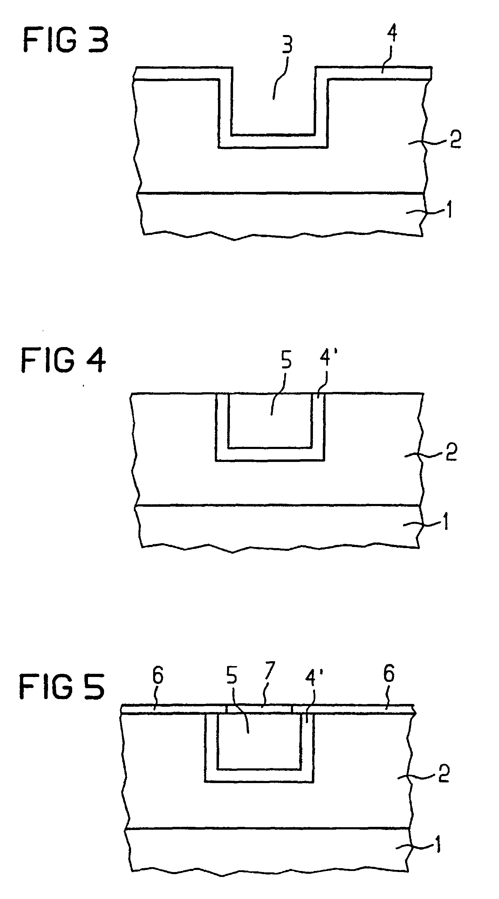

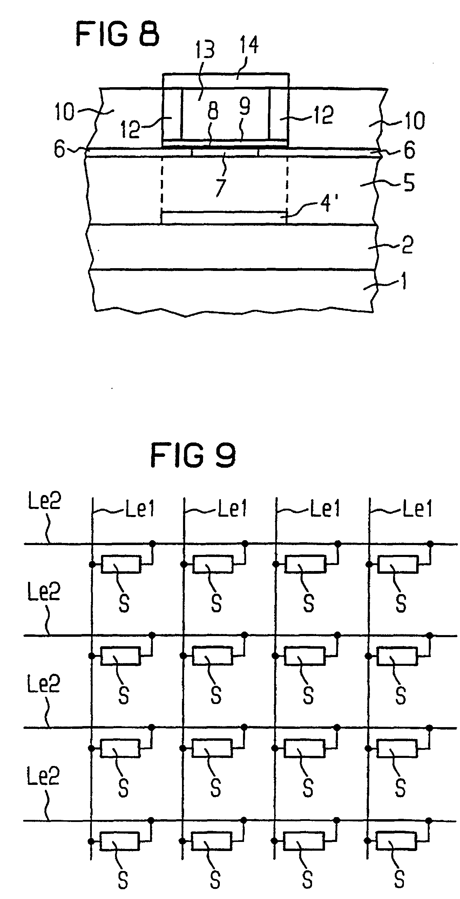

Die in den Figuren 1A, 1B, 2A und 2B gezeigten Speicherelemente und Joche dienen der Erläuterung von Grundlagen magnetoresistiver Speicherelemente. Die Erfindung wird später in Zusammenhang mit den Figuren 3 bis 8 beschrieben.

Ein Speicherelement SE mit magnetoreistivem Effekt ist zwischen einer ersten Leitung L1 zum Beispiel aus AlCu und einer zweiten Leitung L2 zum Beispiel aus AlCu angeordnet. Das Speicherelement SE ist elektrisch sowohl mit der ersten Leitung L1 als auch mit der zweiten Leitung L2 verbunden. Die erste Leitung L1 und die zweite Leitung L2 verlaufen senkrecht zueinander. Am Kreuzungspunkt zwischen der ersten Leitung L1 und der zweiten Leitung L2 ist das Speicherelement SE angeordnet.

Die zweite Leitung L2 ist teilweise von einem Joch J umgeben (siehe Figur 1a). Das Joch J umfaßt ein oberes Teil J1, zwei seitliche Teile J2 sowie zwei untere Teile J3. Das obere Teil J1 grenzt an diejenige Oberfläche der zweiten Leitung L2 an, die dem Speicherelement SE abgewandt ist. Die seitlichen Teile J2 grenzen an das obere Teil J1 und die Seitenwände der zweiten Leitung L2 an. Die unteren Teile J3 grenzen an die seitlichen Teile J2 und den Teil der Oberfläche der zweiten Leitung L2 an, der dem Speicherelement SE benachbart ist. Das Joch J wird aus Eisen gebildet. Darüber hinaus sind alle weichen Ferromagnetika wie Fe, FeNi, Ni, Co oder ähnliches geeignet. Die Dicke D des oberen Teils J1 senkrecht zu der durch die erste Leitung L1 und die zweite L2 aufgespannten Ebene sowie die vergleichbare Dicke der seitlichen Teile I2 parallel zu der von L1 und L2 aufgespannten Ebene betragen ca. 20 Prozent der Breite der Leitung L2. Die Dicke d der unteren Teile J3 senkrecht zu der von der ersten Leitung L1 und der zweiten Leitung L2 aufgespannten Ebene ist in einer bevorzugten von der von der Figur 1a abweichenden Ausführung mindestens gleich der Dicke des Speicherelements SE, maximal etwa 20 Prozent der Breite der Leitbahn L2 (siehe Figur 1b).

Wird die zweite Leitung L2 von einem Strom durchflossen, so wird außerhalb der Leitung L2 ein Magnetfeld H erzeugt. Dieses Magnetfeld erzeugt im Joch J einen magnetischen Fluß Φ = µₒµᵣ H, der im magnetischen Kreis näherungsweise konstant ist. In dem oberen Teil J1 des Joches beträgt der magnetische Fluß Φ = µₒµᵣ F H wobei F = D b die Querschnittsfläche der Jochteile J1 und J2 und b die Ausdehnung des Joches J senkrecht zur Zeichenebene ist. In den unteren Teilen J3 des Joches J beträgt der magnetische Fluß Φ = µₒµᵣ f H, wobei f = d b die Querschnittsfläche der Teile J3 ist. Die unteren Teile J3 des Joches J weisen an den einander zugewandten Stirnflächen magnetische Pole auf. Zwischen den magnetischen Polen P wird ein magnetisches Feld Hₐ erzeugt, für das wegen der Konstanz des magnetischen Flusses näherungsweise gilt: Hₐ = µᵣ F/f H. Da andererseits die maximal erreichbare Magnetfeldstärke in weichmagnetischem Material bei Sättigung durch die Sättigungsmagnetisierung M_{S} des Polschuhmaterials bestimmt wird, gilt: Hₐ = F/f (H + M_{S}) ≈ (F/f) M_{S}. Gegenüber der Sättigungsmagnetisierung M_{S} ist das Magnetfeld H, das in der Größenordnung 10 bis 100 A/cm liegt, meist vernachlässigbar.

Eisen weist eine Sättigungsinduktion von µ_{O} M_{S} (M_{S}: Sättigungsmagnetisierung) = 2,1 T auf. Die maximal erreichbare magnetische Feldstärke Hₐ beträgt somit 1,67 x 10⁶ A/m (21 kOe), falls F/f gleich 1. Bei dieser Betrachtung wurde angenommen, daß die Streufeldverluste zwischen den unteren Teilen J3 des Joches J und dem Speicherelement SE vernachlässigbar sind.

Ein Speicherelement SE' mit magnetoresistivem Effekt ist zwischen eine erste Leitung L1' und eine zweite Leitung L2' geschaltet (siehe Figur 2a). Die erste Leitung L1' wird teilweise von einem Joch J' umgeben. Das Joch J' weist ein unteres Teil J1' und zwei. seitliche Teile J2' auf. Senkrecht zu der durch die erste Leitung L1' und die zweite Leitung L2' aufgespannten Ebene weist der untere Teil J1' des Jochs J' eine Dicke D von ca. 20 Prozent der Breite der Leitung L1' auf (siehe Figur 2b). Die Dicke des Speicherelementes SE' senkrecht zu der die erste Leitung L1' und die zweite Leitung L2' aufgespannten Ebene beträgt d = 20 nm bis ca. 100 nm.

Wird die erste Leitung L1' von einem Strom durchflossen, so entsteht ein Magnetfeld H, das einen magnetischen Fluß Φ in dem Joch J' und dem Speicherelement SE' bewirkt. Dadurch kann abhängig vom Vorzeichen des Stroms das Speicherelement geschaltet werden. Analog dem in Bezug auf Figur 1a und 1b erläuterten Ausführungsbeispiel ergibt sich bei diesem Ausführungsbeispiel, das in Bezug auf die Fertigung vorzuziehen ist, eine vergleichbare Verstärkung und Konzentration des durch den Leiterstrom erzeugten Magnetfeldes am Ort des Speicherelements SE'.

Durch diese Konzentratorvariante entstehen inhomogene Magnetisierungsverteilungen im Speicherelement in den Randbereichen, die an das Joch J2' angrenzen. Diese beeinträchtigen die Schaltungswirkung nicht, müssen aber beim Auslesen berücksichtigt werden.

Anhand der Figuren 3 bis 8 wird im folgenden die Herstellung einer Speicherzellenanordnung für eine 0,18 µm-Technologie beschrieben.

Auf eine Trägerscheibe 1 aus monokristallinem Silizium wird eine erste isolierende Schicht aus SiO₂ aufgebracht. Die erste isolierende Schicht 2 weist eine Dicke von 300 bis 400 nm auf. Unter Verwendung photolithographischer Prozeßschritte wird in der ersten isolierenden Schicht 2 ein erster Graben 3 erzeugt. Der erste Graben 3 weist eine Tiefe von von 200 bis 300 nm, eine Weite von 250 bis 300 nm und eine vom Zellenfeld abhängige Länge von 50 µm bis 400 µm auf.

Anschließend wird eine erste weichmagnetische Schicht 4 aus Fe oder Permalloy (Ni₈₀Fe₂₀) in einer Schichtdicke von 20 bis 60 nm abgeschieden. Die Dicke der ersten weichmagnetischen Schicht 4 beträgt etwa 10 bis 20 Prozent der Weite des ersten Grabens 3. Die Abscheidung kann durch Sputtern, Verdampfen, CVD, Elektroplating oder ähnliches erfolgen (siehe Figur 3). Mit Hilfe photolithographischer Prozeßschritte und anisotropem Ätzen wird die erste weichmagnetische Schicht 4 quer zur Richtung des ersten Grabens 3 strukturiert, so daß sie einen den ersten Graben 3 kreuzenden Streifen aufweist.

Durch Abscheiden einer Metallisierungsschicht, die AlCu enthält und die den Bereich des ersten Grabens 3 vollständig auffüllt, und anschließendes chemisch mechanisches Polieren wird eine erste Leitung 5 gebildet und durch Strukturieren der ersten weichmagnetischen Schicht 4 ein erstes Joch 4' gebildet. Die Ausdehnung des ersten Joches 4' senkrecht zur Zeichenebene wird durch die vorhergehende Strukturierung bestimmt und beträgt 200 bis 300 nm. Das chemisch mechanische Polieren stoppt, sobald die Oberfläche der ersten isolierenden Schicht 2 freigelegt ist (siehe Figur 4).

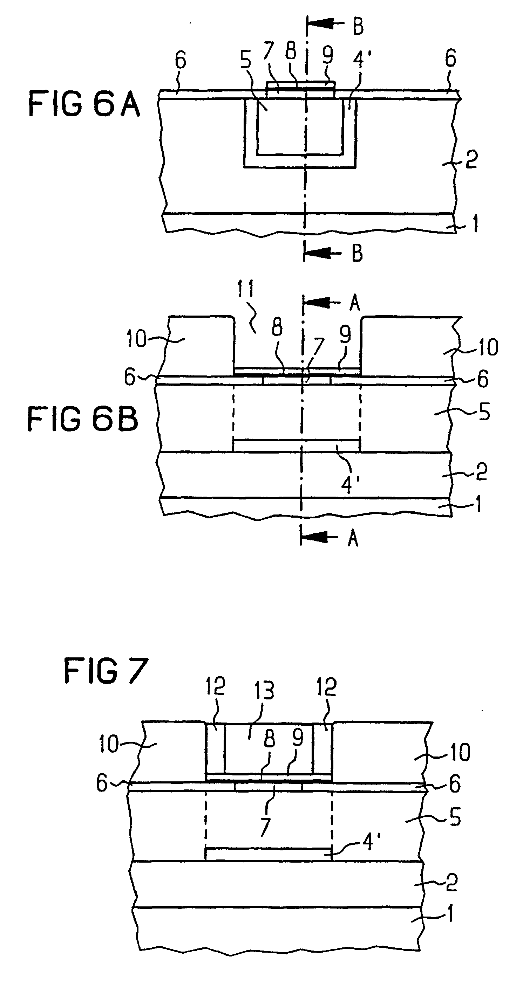

Es wird ganzflächig eine dünne Isolationsschicht 6 aus SiO₂ in einer Schichtdicke von 20 bis 60 nm abgeschieden und mit Hilfe photolithographischer Prozeßschritte so strukturiert, daß die Oberfläche der ersten Leitung 5 teilweise freigelegt wird. Anschließend wird durch Abscheidung und chemisch mechanisches Polieren eine erste ferromagnetische Schicht 7 erzeugt. Die erste ferromagnetische Schicht 7 füllt die Öffnung in der Isolationsschicht 6 aus. Die erste ferromagnetische Schicht 7 steht mit der ersten Leitung 5 in elektrischer Verbindung (siehe Figur 5). Die Dicke der ferromagnetischen Schicht 7 beträgt 20 bis 40 nm, die Breite 180 bis 200 nm und die Tiefe senkrecht zur Zeichenebene 180 bis 200 nm (siehe Figur 5). Die erste ferromagnetische Schicht 7 ist gegen das erste Joch 4' isoliert.

Durch reaktives Sputtern einer 2 bis 4 nm dicken Aluminiumoxidschicht (Al₂O₃) (nicht eingezeichnet) wird an der Oberfläche der ersten ferromagnetischen Schicht 7 eine Tunnelbarriereschicht 8 aus Al₂O₃ gebildet.

Die erste ferromagnetische Schicht 7 wird aus Co (oder einem anderen ferromagnetischen Material) gebildet.

Durch Abscheidung und photolithographische Strukturierung wird eine zweite ferromagnetische Schicht 9 an der Oberfläche der Tunnelschicht abgebildet. Die zweite ferromagnetische Schicht 9 wird aus Co gebildet. Sie weist eine Dicke von 20 bis 60 nm, eine Breite von 180 bis 200 nm und eine Tiefe quer zum Verlauf der ersten Leitung 5 von 200 bis 300 nm auf (siehe Figur 6a und Figur 6b).

Es wird eine zweite isolierende Schicht 10 aus SiO₂ in einer Schichtdicke von 200 bis 300 nm abgeschieden. Mit Hilfe photolithographischer Prozeßschritte wird in der zweiten isolierenden Schicht 10 ein zweiter Graben 11 erzeugt. Am Boden des zweiten Grabens 11 ist die Oberfläche der zweiten ferromagnetischen Schicht 9 mindestens teilweise freigelegt. Der zweite Graben 11 weist eine Weite von 200 bis 300 nm, eine Tiefe von 200 bis 300 nm und eine Länge senkrecht zum Verlauf der ersten Leitung 5 von 50 bis 400 µm auf.

Durch Abscheidung einer zweiten weichmagnetischen Schicht aus Fe oder Ni₈₀Fe₂₀ und anisotropes Rückätzen werden an den Flanken des zweiten Grabens 11 Spacer 12 gebildet. Die Breite der Spacer 12 beträgt 20 bis 60 nm. Sie wird durch die Dicke der abgeschiedenen zweiten weichmagnetischen Schicht bestimmt.

Durch Abscheidung einer Metallisierungsschicht, die AlCu aufweist und eine Dicke von 200 bis 400 nm aufweist, und anschließendes chemisch mechanisches Polieren, das auf der Oberfläche der zweiten isolierenden Schicht 10 aus SiO₂ stoppt, wird in dem zweiten Graben 11 eine zweite Leitung 13 gebildet. Die zweite Leitung 13 füllt den zweiten Graben 11 vollständig auf (siehe Figur 7). Durch Abscheidung einer dritten weichmagnetischen Schicht aus 20 bis 60 nm und Strukturierung mit Hilfe photolithographischer Prozeßschritte wird an der Oberfläche der zweiten Leitung 13 ein Jochteil 14 gebildet, dessen Querschnitt im wesentlichen dem Querschnitt der zweiten ferromagnetischen Schicht 9 entspricht. Das Jochteil 14 und die Spacer 12 bilden gemeinsam ein zweites Joch, das die zweite Leitung 13 teilweise umgibt. Das zweite Joch verstärkt das von der stromdurchflossenen zweiten Leitung 13 erzeugte Magnetfeld am Ort der zweiten ferromagnetischen Schicht 9.

Das erste Joch 4' verstärkt das Magnetfeld, das von der stromdurchflossenen ersten Leitung 5 erzeugt wird.

Die erste Leitung 5 und die zweite Leitung 13 sind über ein Speicherelement, das aus der ersten ferromagnetischen Schicht 7, der Tunnelschicht 8 und der zweiten ferromagnetischen Schicht 9 gebildet wird und das magnetoresistiven Effekt zeigt, verbunden. Durch entsprechende Ansteuerung der ersten Leitung 5 und er zweiten Leitung 13 kann der Widerstand des Speicherelementes gemessen werden. Auf diese Weise wird die in den verschiedenen Magnetisierungszuständen gespeicherte Information ausgelesen.

Zum Einschreiben von Information werden die erste Leitung 5 und die zweite Leitung 13 so angesteuert, daß das aufgrund des Stromflusses resultierende magnetische Feld am Ort der zweiten ferromagnetischen Schicht 9 ausreicht, den Magnetisierungszustand der zweiten ferromagnetischen Schicht 9 zu verändern. Aufgrund der unterschiedlichen Materialeigenschaften Größe und/oder der ferromagnetischen Schichten 7, 9 bleibt der Magnetisierungszustand der ersten ferromagnetischen Schicht 7 dabei unverändert.

Zum Aufbau einer Speicherzellenanordnung, die als Speicherzellen S magnetoresistive Elemente aufweist, werden die Speicherelemente S rasterförmig angeordnet (siehe Figur 9). Jedes Speicherelement S ist dabei zwichen eine erste Leitung Le1 und eine zweite Leitung Le2 geschaltet. Die ersten Leitungen Le1 verlaufen untereinander parallel und kreuzen die zweiten Leitungen Le2, die untereinander ebenfalls parallel verlaufen.

## Patentansprüche

1. Speicherzellenanordnung,
- bei der ein Substrat (1) vorgesehen ist, das eine Hauptfläche aufweist, wobei auf der Hauptfläche eine erste isolierende Schicht (2) angeordnet ist,
- bei der mindestens eine erste Leitung (5) und eine zweite Leitung (13) und ein Speicherelement (7, 8, 9) mit magnetoresistivem Effekt vorgesehen sind,
- bei der ein erstes Joch (4') vorgesehen ist, durch das eine der Leitungen (5), die bei einem Schreibzugriff mit Strom versorgt wird, teilweise umgeben wird,
- bei der das erste Joch (4') so angeordnet ist, daß sich ein Magnetfluß durch das erste Joch (4') im wesentlichen im Speicherelement (7, 8, 9) schließt,
- bei der in der ersten isolierenden Schicht (2) ein Graben (3) ausgebildet ist, auf dessen Boden und an dessen Flanken das erste Joch (4') angeordnet ist,
**dadurch gekennzeichnet, daß**
- das Speicherelement (7, 8, 9) an einer Kreuzungsstelle zwischen die erste Leitung (5) und die zweite Leitung (13) geschaltet ist,
- das erste Joch (4') magnetisierbares Material mit einer relativen Permeabilität von mindestens 10 enthält,
- die erste Leitung (5) in dem Graben (3) verläuft und
- der Graben eine von der Hauptfläche des Substrats (1) abgewandte Öffnung aufweist.

2. Speicherzellenanordnung nach Anspruch 1, bei der das erste Joch (J) weichmagnetisches, ferromagnetisches Material enthält.

3. Speicherzellenanordnung nach Anspruch 2,
- bei der das Substrat eine Trägerscheibe (1) mit der Hauptfläche umfaßt und
- bei der das Speicherelement (7, 8, 9) oberhalb des Joches und an der Oberfläche der ersten Leitung (5) angeordnet ist.

4. Speicherzellenanordnung nach Anspruch 2,
- bei der das Substrat eine Trägerscheibe (1) mit der Hauptfläche umfaßt,
- bei der oberhalb des Speicherelementes (7, 8, 9) die zweite Leitung (13) angeordnet ist,
- bei der ein zweites Joch (12, 14) oberhalb des Speicherelementes (7, 8, 9) an die Flanken und an die dem Speicherelement abgewandte Oberfläche der zweiten Leitung (13) angrenzt,
- bei der eine zweite isolierende Schicht (10) vorgesehen ist, die die zweite Leitung (13) und das zweite Joch (12, 14) teilweise umgibt.

5. Speicherzellenanordnung nach einem der Ansprüche 1 oder 2,
- bei der das Joch (4') und ein zweites Joch (12, 14) jeweils magnetisierbares Material mit einer relativen Permeabilität von mindestens 10 enthalten,
- bei der das zweite Joch so angeordnet ist, daß sich ein Magnetfluß durch das zweite Joch (12, 14) im wesentlichen im Speicherelement (7, 8, 9) schließt.

6. Speicherzellenanordnung nach Anspruch 4,
- bei der das Speicherelement (7, 8, 9) oberhalb des ersten Joches (4') und der ersten Leitung (5) angeordnet ist.

7. Speicherzellenanordnung nach einem der Ansprüche 1 bis 3,
- bei der untereinander parallel verlaufende erste Leitungen und untereinander parallel verlaufende zweite Leitungen vorgesehen sind,
- bei der je ein Speicherelement mit magnetoresistivem Effekt und jeweils mindestens ein Joch, das eine der Leitungen teilweise umgibt, das magnetisierbares Material mit einer Permeabilität von mindestens 10 enthält und das so angeordnet ist, daß sich ein Magnetfluß durch das Joch im wesentlichen über das Speicherelement schließt, zwischen ein Paar mit einer der ersten Leitungen und einer der zweiten Leitungen geschaltet ist.

8. Speicherzellenanordnung nach Anspruch 7,
- bei der ein weiteres Joch, das eine andere der Leitungen teilweise umgibt, das magnetisierbares Material mit einer Permeabilität von mindestens 10 enthält und das so angeordnet ist, daß sich ein Magnetfluß durch das weitere Joch im wesentlichen über das Speicherelement schließt, zwischen ein Paar mit einer der ersten Leitungen und einer der zweiten Leitungen geschaltet ist.

9. Speicherzellenanordnung nach einem der Ansprüche 1 bis 8,
- bei der das Speicherelement bzw. die Speicherelemente mindestens eines der Elemente Fe, Ni, Co, Cr, Mn, Gd, Dy oder mindestens eines der Materialien Al₂O₃, NiO, HfO₂, TiO₂, NbO, SiO₂ enthält bzw. enthalten,
- bei der das Joch bzw. die Joche mindestens eines der Elemente Fe, Ni, Co, Cr, Mn, Gd, Dy enthält bzw. enthalten.

10. Verfahren zur Herstellung einer Speicherzellenanordnung,
- bei dem auf eine Hauptfläche einer Trägerscheibe (1) eine erste isolierende Schicht (2) aufgebracht wird und ein erster Graben (3) erzeugt wird,
- bei dem ein erstes Joch (4') aus magnetisierbarem Material an den Seitenwänden und auf dem Boden des Grabens (3) erzeugt wird und
- bei dem oberhalb eines Speicherelementes (7, 8, 9) mit magnetoresistivem Effekt eine zweite Leitung (13) erzeugt wird,
**dadurch gekennzeichnet, daß**
- der erste Graben (3) anschließend an das Aufbringen der isolierenden Schicht (2) auf die Hauptfläche der Trägerscheibe (1) erzeugt wird,
- das magnetisierbare Material mit einer Permeabilität von mindestens 10 erzeugt wird,
- in dem ersten Graben (3) eine erste Leitung (5) erzeugt wird,
- oberhalb des ersten Jochs (4') das Speicherelement (7, 8, 9) erzeugt wird, das mit der ersten Leitung (5) verbunden ist, und
- die zweite Leitung (13) mit dem Speicherelement (7, 8, 9) verbunden ist.

11. Verfahren nach Anspruch 10,
- bei dem zum Erzeugen des ersten Joches (4') ein zweite isolierende Schicht (10) aufgebracht wird, in der ein zweiter Graben (11) erzeugt wird,
- bei dem an den Flanken des zweiten Grabens (11) Spacer (12) aus magnetisierbarem Material mit einer Permeabilität von mindestens 10 gebildet werden,
- bei dem in dem zweiten Graben (11) die zweite Leitung (13) erzeugt wird,
- bei dem ein Jochteil (14) aus magnetisierbarem Material mit einer Permeabilität von mindestens 10 erzeugt wird, das oberhalb des Speicherelementes (7, 8, 9) die zweite Leitung (13) teilweise bedeckt und das mit den Spacern (12) aus magnetisierbarem Material in Verbindung steht, so daß die Spacer (12) und das Jochteil (14) ein zweites Joch bilden.

12. Verfahren nach Anspruch 10 oder 11, bei dem die erste Leitung (5) und/oder die zweite Leitung (13) durch Abscheiden einer Metallschicht und chemisch mechanisches Polieren gebildet werden.

## Claims

1. Memory cell array,
- in which a substrate (1) is provided which has a main face, a first insulating layer (2) being arranged on the main face,
- in which a first line (5) and a second line (13) and a memory element (7, 8, 9) with a magnetoresistive effect are provided,
- in which a first yoke (4') is provided, by means of which one of the lines (5) which is supplied with current during a write access is partially surrounded,
- in which the first yoke (4') is arranged in such a way that a magnetic flux path through the first yoke (4') is closed essentially in the memory element (7, 8, 9),
- in which a trench (3), on the bottom of which and on the sidewalls of which the first yoke (4') is arranged, is formed in the first insulating layer (2), **characterized in that**
- the memory element (7, 8, 9) is connected at the point of intersection between the first line (5) and the second line (13),
- the first yoke (4') contains magnetizable material with a relative permeability of at least 10,
- the first line (5) extends in the trench (3), and
- the trench has an opening facing away from the main face of the substrate (1).

2. Memory cell array according to Claim 1, in which the first yoke (J) contains soft-magnetic, ferromagnetic material.

3. Memory cell array according to Claim 2,
- in which the substrate comprises a carrier wafer (1) with the main face, and
- in which the memory element (7, 8, 9) is arranged above the yoke and on the surface of the first line (5).

4. Memory cell array according to Claim 2,
- in which the substrate comprises a carrier wafer (1) with the main face,
- in which the second line (13) is arranged above the memory element (7, 8, 9),
- in which a second yoke (12, 14) above the memory element (7, 8, 9) is adjacent to the edges and to the surface of the second line (13) facing away from the memory element,
- in which a second insulating layer (10) which partially surrounds the second line (13) and the second yoke (12, 14) is provided.

5. Memory cell array according to one of Claims 1 or 2,
- in which the yoke (4') and a second yoke (12, 14) each contain magnetizable material with a relative permeability of at least 10,
- in which the second yoke is arranged in such a way that a magnetic flux path through the second yoke (12, 14) is closed essentially in the memory element (7, 8, 9).

6. Memory cell array according to Claim 4,
- in which the memory element (7, 8, 9) is arranged above the first yoke (4') and the first line (5).

7. Memory cell array according to one of Claims 1 to 3,
- in which first lines which are parallel to one another and second line which are parallel to one another are provided,
- in which in each case one memory element with magnetoresistive effect and in each case at least one yoke which partially surrounds one of the lines, contains magnetizable material with a permeability of at least 10 and is arranged in such a way that a magnetic flux path through the yoke is closed essentially by means of the memory element is switched between a pair with one of the first lines and one of the second lines.

8. Memory cell array according to Claim 7,
- in which a further yoke which partially surrounds another of said lines, contains magnetizable material with a permeability of at least 10 and is arranged in such a way that a magnetic flux path through the further yoke is closed essentially by means of the memory element is switched between a pair with one of the first lines and one of the second lines.

9. Memory cell array according to one of Claims 1 to 8,
- in which the memory element or memory elements contain at least one of the elements Fe, Ni, Co, Cr, Mn, Gd, Dy or at least one of the materials Al₂O₃, NiO, HfO₂, TiO₂, NbO, SiO₂,
- in which the yoke or the yokes contain(s) at least one of the elements Fe, Ni, Co, Cr, Mn, Gd, Dy.

10. Method for manufacturing a memory cell array,
- in which a first insulating layer (2) is applied to a main face of a carrier wafer (1) and a first trench (3) is produced,
- in which a first yoke (4') is produced from magnetizable material on the sidewalls and on the bottom of the trench (3), and
- in which a second line (13) is produced above a memory element (7, 8, 9) with a magnetoresistive effect, **characterized in that**
- the first trench (3) is produced subsequent to the application of the insulating layer (2) to the main face of the carrier wafer (1),
- the magnetizable material is produced with a permeability of at least 10,
- the first line (5) is produced in the first trench (3),
- the memory element (7, 8, 9) is produced above the first yoke (4') and is connected to the first line (5), and
- the second line (13) is connected to the memory element (7, 8, 9).

11. Method according to Claim 10,
- in which, in order to produce the first yoke (4'), a second insulating layer (10) in which a second trench (11) is produced is applied,
- in which spacers made of magnetizable material with a permeability of at least 10 are formed on the sidewalls of the second trench (11),
- in which the second line (13) is produced in the second trench (11),
- in which a yoke part (14) is produced from magnetizable material with a permeability of at least 10 and partially covers the second line (13) above the memory element (7, 8, 9) and is connected to the spacers (12) made of magnetizable material, in such a way that the spacers (12) and the yoke component (14) form a second yoke.

12. Method according to Claim 10 or 11, in which the first line (5) and/or the second line (13) are formed by depositing a metal layer and chemical-mechanical polishing.

## Revendications

1. Dispositif de cellule de mémoire,
- dans lequel il est prévu un substrat (1) qui a une surface principale, une première couche (2) isolante étant disposée sur la surface principale,
- dans lequel il est prévu au moins un premier conducteur (5) et un deuxième conducteur (13) et un élément (7, 8, 9) de mémoire à effet magnétorésistant,
- dans lequel il est prévu une première culasse (4') de laquelle l'un des conducteurs (5) qui est alimenté en courant lors d'un accès en écriture est entouré en partie,
- dans lequel la première culasse (4') est disposée de façon à ce qu'un flux magnétique par la première culasse (4') se ferme sensiblement dans l'élément (7, 8, 9) de mémoire,
- dans lequel il est constitué dans la première couche (2) isolante un sillon (3) sur le fond et les flancs duquel est disposée la première culasse (4'),
**caractérisé en ce que**
- l'élément (7, 8, 9) de mémoire est monté en un point d'intersection entre le premier conducteur (5) et le deuxième conducteur (13),
- la première culasse (4') contient du matériau magnétisable ayant une perméabilité relative d'au moins 10,
- le premier conducteur (5) s'étend dans le sillon (3) et
- le sillon a une ouverture éloignée de la surface principale du substrat (1).

2. Dispositif de cellule de mémoire suivant la revendication 1, dans lequel la première culasse (J) contient du matériau ferromagnétique à magnétisme doux.

3. Dispositif de cellule de mémoire suivant la revendication 2,
- dans lequel le substrat comprend une tranche (1) servant de support ayant la surface principale et
- dans lequel l'élément (7, 8, 9) de mémoire est disposé au-dessus de la culasse et à la surface du premier conducteur (5).

4. Dispositif de cellule de mémoire suivant la revendication 2,
- dans lequel le substrat comprend une tranche (1) servant de support ayant la surface principale,
- dans lequel le deuxième conducteur (13) est disposé au-dessus de l'élément (7, 8, 9) de mémoire,
- dans lequel une deuxième culasse (12, 14) est adjacente au-dessus de l'élément (7, 8, 9) de mémoire au flanc et à la surface, éloignée de l'élément de mémoire, du deuxième conducteur (13),
- dans lequel il est prévu une deuxième couche (10) isolante qui entoure en partie le deuxième conducteur (13) et la deuxième culasse (12, 14).

5. Dispositif de cellule de mémoire suivant l'une des revendications 1 ou 2,
- dans lequel la culasse (4') et une deuxième culasse (12, 14) contiennent respectivement du matériau magnétisable ayant une perméabilité relative d'au moins 10,
- dans lequel la deuxième culasse est disposée de manière à ce qu'un flux magnétique dans la deuxième culasse (12, 14) se ferme sensiblement dans l'élément (7, 8, 9) de mémoire.

6. Dispositif de cellule de mémoire suivant la revendication 4,
- dans lequel l'élément (7, 8, 9) de mémoire est disposé au-dessus de la première culasse (4') et du premier conducteur (5).

7. Dispositif de cellule de mémoire suivant l'une des revendications 1 à 3,
- dans lequel il est prévu des premiers conducteurs s'étendant parallèlement entre eux et des deuxièmes conducteurs s'étendant parallèlement entre eux,
- dans lequel respectivement un élément de mémoire ayant un effet magnétorésistant et respectivement au moins une culasse, qui entoure en partie l'un des conducteurs qui contient le matériau magnétisable ayant une perméabilité d'au moins 10 et qui est disposée de façon à ce qu'un flux magnétique par la culasse se ferme sensiblement sur l'élément de mémoire, est montée entre une paire ayant l'un des premiers conducteurs et l'un des deuxièmes conducteurs.

8. Dispositif de cellule de mémoire suivant la revendication 7,
- dans lequel une autre culasse, qui entoure en partie un autre des conducteurs, qui contient du matériau magnétisable d'une perméabilité d'au moins 10 et qui est disposée de façon à ce qu'un flux magnétique passant par l'autre culasse se ferme sensiblement sur l'élément de mémoire, est montée entre une paire de l'un des premiers conducteurs et de l'un des deuxièmes conducteurs.

9. Dispositif de cellule de mémoire suivant l'une des revendications 1 à 8,
- dans lequel l'élément de mémoire ou les éléments de mémoire contient ou contiennent au moins l'un des éléments Fe, Ni, Co, Cr, Mn, Gd, Dy ou au moins l'un des matériaux Al₂O₃, NiO, HfO₂, TiO₂, NbO, SiO₂,
- dans lequel la culasse ou les culasses contient ou contiennent au moins l'un des éléments Fe, Ni, Co, Cr, Mn, Gd, Dy.

10. Procédé de production d'un dispositif de cellule de mémoire,
- dans lequel on dépose, sur une surface principale d'une tranche (1) servant de support, une première couche (2) isolante et on produit un premier sillon (3),
- dans lequel on produit une première culasse (4') en matériau magnétisable sur les parois latérales et sur le fond du sillon (3) et
- dans lequel on produit au-dessus d'un élément (7, 8, 9) de mémoire à effet magnétorésistant un deuxième conducteur (13),
**caractérisé en ce que**
- on produit le premier sillon (3) à la suite du dépôt de la couche (2) isolante sur la surface principale de la tranche (1) servant de support,
- on produit le matériau magnétisable en lui donnant une perméabilité d'au moins 10,
- on produit dans le premier sillon (3) un premier conducteur (5),
- on produit au-dessus de la première culasse (4') l'élément (7, 8, 9) de mémoire qui est relié au premier conducteur (5), et
- on relie le deuxième conducteur (13) à l'élément (7, 8, 9) de mémoire.

11. Procédé suivant la revendication 10,
- dans lequel, pour produire la première culasse (4'), on dépose une deuxième couche (10) isolante dans laquelle on produit un deuxième sillon (11),
- dans lequel on forme sur les flancs du deuxième sillon (11) des espaceurs (12) en matériau magnétisable d'une perméabilité d'au moins 10,
- dans lequel on produit le deuxième conducteur (13) dans le deuxième sillon (11),
- dans lequel on produit une partie (14) de culasse en matériau magnétisable d'une perméabilité d'au moins 10, qui recouvre en partie le deuxième conducteur (13) au-dessus de l'élément (7, 8, 9) de mémoire et qui est en liaison avec les espaceurs (12) en matériau magnétisable, de sorte que les espaceurs (12) et la partie (14) de culasse forment une deuxième culasse.

12. Procédé suivant la revendication 10 ou 11,
dans lequel on forme le premier conducteur (5) et/ou le deuxième conducteur (13) par dépôt d'une couche métallique et par polissage chimiomécanique.
